# DEMANDE DE BREVET EUROPEEN

(11) **EP 4 633 035 A1**
(43) Date de publication de la demande: **15.10.2025**
(21) Numéro de dépôt: 25167257.2
(22) Date de dépôt: 31.03.2025
(51) Int. Cl.: H02S 50/15, H10F 71/00

(54) **PROCÉDÉ DE TRAITEMENT POUR AUGMENTER LE RENDEMENT D'UNE CELLULE PHOTOVOLTAÏQUE**

(30) Priorité: 08.04.2024 FR 2403604
(71) Demandeur: Commissariat à l'Energie Atomique et aux Energies Alternatives, 75015 Paris (FR)
(72) Inventeur: JERONIMO, Pédro, 38054 GRENOBLE CEDEX 09 (FR)
(74) Mandataire: INNOV-GROUP

(57) **Abrégé**

L'invention concerne un procédé de traitement pour augmenter le rendement d'une cellule photovoltaïque (1), comportant des étapes de :
- Positionnement de la cellule photovoltaïque (1) sur un convoyeur (3) le long duquel est positionnée une matrice de sources lumineuses,
- Acquisition d'une image (IMG) de la cellule photovoltaïque (1) sur le convoyeur (3) à l'aide d'une caméra (4),
- Division de l'image acquise en plusieurs zones, dites premières zones à éclairer et deuxièmes zones à ne pas éclairer,
- Création d'une séquence de contrôle des sources lumineuses de la matrice à l'aide de l'image divisée en plusieurs zones,
- Ladite séquence de contrôle étant définie par plusieurs instants successifs,
- A chaque instant de la séquence de contrôle et à partir de l'image divisée en plusieurs zones, mettre dans l'état actif chaque source lumineuse située en vis-à-vis d'une première zone à éclairer définie sur l'image acquise et mettre dans l'état inactif chaque source lumineuse située en vis-à-vis d'une deuxième zone à ne pas éclairer définie sur l'image acquise.

## Description

### Domaine technique de l'invention

La présente invention se rapporte à un procédé de traitement pour augmenter le rendement d'une cellule photovoltaïque.

### Etat de la technique

Les cellules photovoltaïques à hétérojonction de silicium (appelées SHJ) sont connues pour voir leur rendement de conversion énergétique s'améliorer sous l'action conjuguée de l'éclairement et de la température. Ainsi, il est à présent courant de procéder à un traitement dit de bonification (appelé "light soaking") des empilements destinés à former les cellules photovoltaïques SHJ, afin d'en augmenter leur rendement de conversion. Le document WO2013/001440 décrit un exemple de procédé de traitement de cellules photovoltaïques de type SHJ comprenant un substrat en silicium cristallin dopé n. Dans ce procédé de traitement, la cellule photovoltaïque est soumise à un flux lumineux d'irradiance supérieure ou égal à 500 W/m2 pendant une durée d'environ 10 heures, tout en étant chauffée à une température comprise entre 20 °C et 200 °C.

La demande de brevet FR3099294A1 décrit un procédé de traitement d'un empilement dit précurseur de cellule photovoltaïque à hétérojonction. Ce procédé est mis en œuvre en fin de fabrication et consiste principalement à exposer ledit empilement à un rayonnement électromagnétique intense (supérieur à 200kW/m²) pendant une durée relativement courte (une dizaine de secondes). Grâce à cette exposition temporaire et intense au rayonnement, on a constaté une bonification de la cellule et une augmentation de son rendement en fonctionnement.

La demande de brevet WO2023/247326A1 décrit également un procédé particulier d'amélioration du rendement de conversion d'une cellule photovoltaïque.

Ces solutions connues sont cependant très énergivores, pour à la fois obtenir une intensité d'éclairement forte et un refroidissement suffisant des sources lumineuses.

Le but de l'invention est de proposer une solution pour améliorer le rendement de conversion d'une cellule photovoltaïque, ou autrement dit pour la bonifier, qui soit moins énergivore que celles connues dans l'état de la technique.

### Exposé de l'invention

Ce but est atteint par un procédé de traitement pour augmenter le rendement d'une cellule photovoltaïque, le procédé comportant des étapes de :
- Positionnement de la cellule photovoltaïque sur un convoyeur le long duquel est positionnée une matrice de sources lumineuses, chaque source lumineuse de la matrice étant adressable et contrôlable de manière individualisée en prenant un premier état dit actif dans lequel elle est allumée ou un deuxième état dit inactif dans lequel elle est éteinte, ladite matrice de sources lumineuses comportant plusieurs lignes et colonnes de sources lumineuses juxtaposées,
- Acquisition d'une image de la cellule photovoltaïque sur le convoyeur à l'aide d'une caméra,
- Division de l'image acquise en plusieurs zones, dites premières zones à éclairer et deuxièmes zones à ne pas éclairer,
- Création d'une séquence de contrôle des sources lumineuses de la matrice à l'aide de l'image divisée en plusieurs zones,
- Ladite séquence de contrôle étant définie par plusieurs instants successifs,
- Détection d'un premier instant auquel la cellule photovoltaïque est présente en vis-à-vis d'une première colonne de la matrice de sources lumineuses et exécution de ladite séquence de contrôle des sources lumineuses à partir dudit premier instant détecté, en tenant compte de l'image divisée en plusieurs zones,
- A chaque instant de la séquence de contrôle et à partir de l'image divisée en plusieurs zones, mettre dans l'état actif chaque source lumineuse située en vis-à-vis d'une première zone à éclairer définie sur l'image acquise et mettre dans l'état inactif chaque source lumineuse située en vis-à-vis d'une deuxième zone à ne pas éclairer définie sur l'image acquise.

Selon une particularité, lesdits instants successifs de la séquence de contrôle sont déterminés en tenant compte de la vitesse d'avancée du convoyeur.

Selon une autre particularité, chaque zone desdites plusieurs zones est définie par au moins un pixel.

Selon une autre particularité, l'image acquise est en noir et blanc et l'étape de division de l'image en plusieurs zones consiste à :
- Affecter un état 0 ou 1 lorsque le pixel de l'image acquise est blanc,
- Affecter respectivement l'état 1 ou 0 lorsque le pixel de l'image acquise est noir.

Selon une autre particularité, chaque source lumineuse de la matrice de sources lumineuses est formée d'une diode électroluminescente et, dans la séquence de contrôle, l'état de chaque diode électroluminescente est déterminé en fonction de l'état affecté à chaque pixel de l'image.

Selon une autre particularité, la séquence de contrôle consiste à commander chaque diode électroluminescente de la matrice de diodes électroluminescentes pour émettre à une puissance déterminée en fonction de sa position dans la matrice de diodes électroluminescentes.

L'invention concerne également un système de traitement pour augmenter le rendement d'une cellule photovoltaïque employé pour mettre en œuvre le procédé tel que défini dans l'une des revendications précédentes, le système comportant :
- Un convoyeur le long duquel est positionnée une matrice de sources lumineuses, chaque source lumineuse de la matrice étant adressable et contrôlable de manière individualisée en prenant un premier état dit actif dans lequel elle est allumée ou un deuxième état dit inactif dans lequel elle est éteinte, ladite matrice de sources lumineuses comportant plusieurs lignes et colonnes de sources lumineuses juxtaposées,
- Une caméra configurée pour acquérir une image de la cellule photovoltaïque sur le convoyeur,
- Une unité de traitement et de commande configurée pour :
   ∘ Diviser chaque image acquise en plusieurs zones, dites premières zones à éclairer et deuxièmes zones à ne pas éclairer,
   ∘ Créer une séquence de contrôle des sources lumineuses de la matrice à l'aide de l'image divisée en plusieurs zones,
   ∘ Ladite séquence de contrôle étant définie par plusieurs instants successifs,
   ∘ A chaque instant de la séquence de contrôle, mettre dans l'état actif chaque source lumineuse située en vis-à-vis d'une première zone de l'image et mettre dans l'état inactif chaque source lumineuse située en vis-à-vis d'une deuxième zone de la cellule photovoltaïque,
- Des moyens de détection d'un premier instant auquel la cellule photovoltaïque est présente en vis-à-vis d'une première colonne de la matrice de sources lumineuses,
- Ladite unité de traitement et de commande étant configurée pour exécuter ladite séquence de contrôle des sources lumineuses à partir dudit premier instant détecté.

Selon une particularité, lesdits instants successifs de la séquence de contrôle sont déterminés en tenant compte de la vitesse d'avancée du convoyeur.

Selon une autre particularité, chaque zone desdites plusieurs zones est définie par au moins un pixel.

Selon une autre particularité, l'image acquise est en noir et blanc et l'unité de traitement et de commande est configurée pour diviser l'image en plusieurs zones en :
- Affectant un état 0 ou 1 lorsque le pixel de l'image acquise est blanc,
- Affectant respectivement l'état 1 ou 0 lorsque le pixel de l'image acquise est noir.

Selon une autre particularité, chaque source lumineuse de la matrice de sources lumineuses est formée d'une diode électroluminescente et, dans la séquence de contrôle, l'état de chaque diode électroluminescente est déterminé en fonction de l'état affecté à chaque pixel de l'image.

Selon une autre particularité, la séquence de contrôle consiste à commander chaque diode électroluminescente de la matrice de diodes électroluminescentes pour émettre à une puissance déterminée en fonction de sa position dans la matrice de diodes électroluminescentes.

Selon une autre particularité, la matrice de sources lumineuses est intégrée à un tunnel d'éclairement traversé par le convoyeur.

### Brève description des figures

D'autres caractéristiques et avantages vont apparaître dans la description détaillée qui suit faite en regard des dessins annexés dans lesquels :
- La figure 1 représente un exemple d'empilement de couches formant une cellule photovoltaïque à hétérojonction ;
- La figure 2 représente de manière schématique l'architecture du système employé pour la mise en œuvre du procédé de l'invention ;
- Les figures 3A et 3B illustrent le principe de mise en œuvre du procédé de l'invention ;
- La figure 4 illustre le principe de pixellisation de l'image utilisé dans le procédé de l'invention ;
- La figure 5 représente de manière schématique, le principe de réalisation de la matrice de diodes électroluminescentes employée dans le tunnel d'éclairement ;
- La figure 6 représente un exemple d'algorithme employé pour l'étape de traitement de l'image mise en œuvre dans le procédé de l'invention ;
- La figure 7 illustre le principe de séparation de la matrice de diodes électroluminescentes en plusieurs zones d'éclairement distinctes en puissance ;

### Description détaillée d'au moins un mode de réalisation

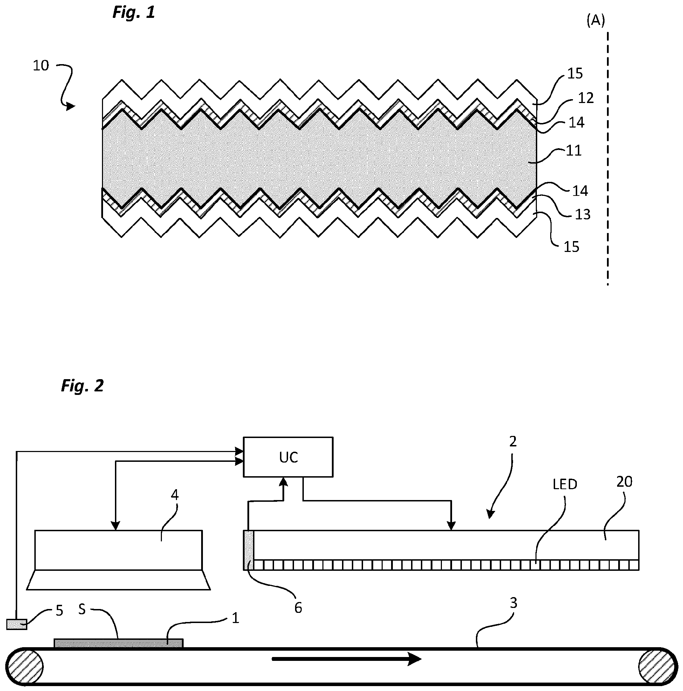

Le procédé de l'invention s'applique au traitement d'une cellule photovoltaïque 1, notamment une cellule photovoltaïque à hétérojonction de silicium (SJH). Celle-ci est formée d'un empilement 10 de couches, suivant la direction (A). De manière non limitative, comme décrit dans la demande de brevet FR3099294A1 et représenté sur la figure 1, l'empilement 10 peut présenter l'architecture suivante :
- Un substrat 11 en silicium cristallin, par exemple dopé n ;
- Une première couche de passivation 14 en silicium amorphe hydrogéné (et de préférence intrinsèque) disposée sur la première face du substrat 11 ;
- Une première couche de silicium amorphe 12, disposée sur la première couche de passivation 14 et dopée d'un premier type de conductivité ;
- Une première couche d'oxyde transparent conducteur 15 disposée sur la première couche dopée de silicium amorphe 12 ;
- Une deuxième couche de passivation 14 en silicium amorphe hydrogéné (et de préférence intrinsèque) disposée sur la deuxième face du substrat 11 ;
- Une deuxième couche de silicium amorphe 13, disposée sur la deuxième couche de passivation 14 et dopée d'un deuxième type de conductivité opposé au premier type de conductivité ; et
- Une deuxième couche d'oxyde transparent conducteur 15 disposée sur la deuxième couche dopée de silicium amorphe 13.

Pour la mise en œuvre du procédé de l'invention, le système employé comporte une source d'émission 2 de rayonnements électromagnétiques. Cette source d'émission 2 est composée de plusieurs sources lumineuses, chaque source lumineuse étant composée d'une ou plusieurs diodes électroluminescentes (référencées LED). Pour la suite de la description et de manière avantageuse, on considère que chaque source lumineuse est composée d'une seule diode électroluminescente.

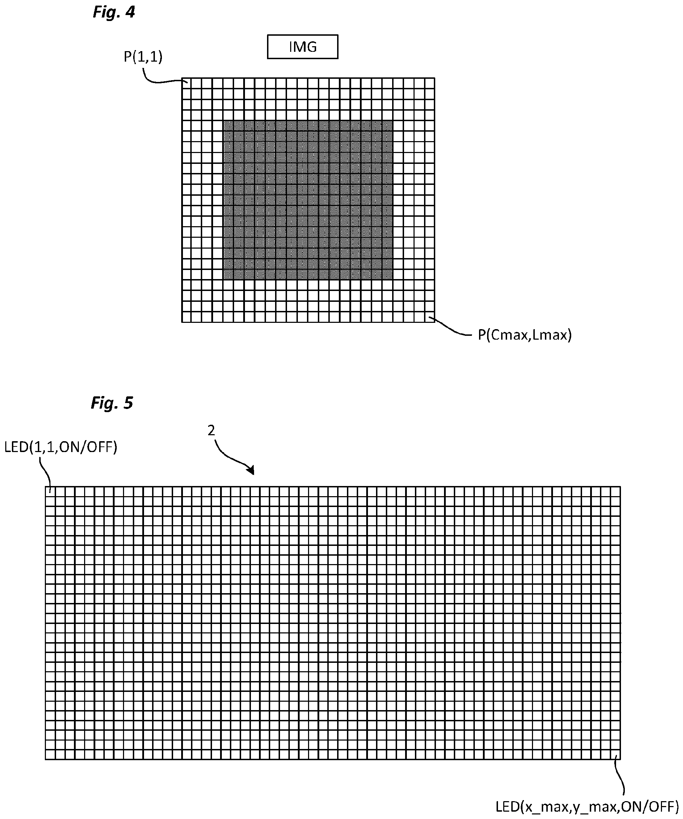

Comme représenté sur la figure 2 et la figure 5, la source d'émission 2 est plus précisément composée d'une matrice de diodes électroluminescentes (LED), dans laquelle les diodes électroluminescentes sont alignées suivant plusieurs colonnes parallèles et plusieurs lignes parallèles. Les lignes et les colonnes de diodes électroluminescentes sont avantageusement espacées de manière régulière. La matrice est avantageusement de forme rectangulaire.

Dans la matrice de diodes électroluminescentes, chaque ligne comporte un même nombre de diodes électroluminescentes et chaque colonne comporte un même nombre de diodes électroluminescentes. Les diodes électroluminescentes de la matrice ont par exemple toutes une taille identique et sont avantageusement toutes identiques (par exemple de forme carrée).

Dans le cadre de l'invention et comme illustré par la figure 5, chaque diode électroluminescente de la matrice est identifiée par une coordonnée et par son état, selon l'expression suivante :
LED(colonne=x, ligne=y, état=0/1, P)

Dans laquelle :
- x représente donc le numéro de la colonne dans la matrice de diodes électroluminescentes ;
- y représente le numéro de la ligne dans la matrice de diodes électroluminescentes ;
- état=0/1 correspond à l'état actif (1) ou inactif (0) de la diode électroluminescente ;
- P correspond à la puissance émise par la diode électroluminescente (pour des raisons de simplification, ce paramètre n'apparaît pas forcément sur les dessins annexés) ;

De manière non limitative, chaque diode électroluminescente est positionnée de manière à émettre suivant une direction principale qui est normale à la surface S de la cellule photovoltaïque 1 à traiter.

De manière simplifiée, on définit la puissance P émise par chaque diode électroluminescente de la matrice.

Il faut noter que le rayonnement émis par la diode électroluminescente est appliqué pendant une durée de traitement (appelée durée d'exposition) déterminée, pouvant varier en fonction de l'irradiance et de la longueur d'onde du rayonnement émis. Pour rappel, l'irradiance, appelée aussi éclairement énergétique ou densité surfacique de puissance lumineuse, représente la puissance du rayonnement électromagnétique reçu par unité de surface, cette unité de surface étant orientée perpendiculairement à la direction du rayonnement électromagnétique émis.

Le rayonnement électromagnétique peut être monochromatique (une seule longueur d'onde) ou polychromatique (plusieurs composantes de longueurs d'ondes différentes). De manière plus précise, le rayonnement peut être émis à au moins une longueur d'onde comprise entre 400nm et 1100nm.

De manière non limitative, selon les cas de fonctionnement, le rayonnement électromagnétique peut être émis à une irradiance comprise entre 1kW/m2 à 100kW/m2 et pendant une durée comprise entre 5 secondes à 30 minutes.

A titre d'exemple, le rayonnement électromagnétique peut être émis à une irradiance supérieure ou égale à 8kW/m2 et pendant une durée inférieure ou égale à 4 minutes. Le rayonnement électromagnétique peut également être émis à une irradiance supérieure ou égale à 50kW/m2 et pendant une durée inférieure ou égale à 15 secondes.

Pendant l'émission du rayonnement, la température de la cellule peut être avantageusement maintenue à une valeur la plus stable possible, par exemple choisie entre 100°C et 250°C (à confirmer). Pour cela, le système peut être doté de moyens de gestion de la température (non décrit dans la présente demande), tels que décrit dans la demande de brevet EP4305674A1**.**

Dans le cadre de l'invention, la matrice de diodes électroluminescentes est intégrée à un tunnel d'éclairement 20, à l'intérieur duquel est amené la cellule photovoltaïque 1 à traiter. Le système comporte également un convoyeur 3 ou équivalent, agencé pour traverser le tunnel d'éclairement 20 et sur lequel est positionnée la cellule photovoltaïque 1 à traiter. Plusieurs cellules photovoltaïques peuvent ainsi être transportées à travers le tunnel d'éclairement, pour être traitées successivement, en étant mise en mouvement par le convoyeur 3.

A titre d'exemple, la matrice comporte 200 colonnes et 50 lignes de diodes électroluminescentes. En considérant que chaque diode électroluminescente se présente sous la forme d'un carré de 5mm/5mm, la matrice fait donc 1 mètre en longueur et 25cm en largeur.

Sur le convoyeur 3, chaque cellule photovoltaïque 1 peut être calée dans les deux dimensions du plan du convoyeur par des moyens appropriés. La position de chaque cellule photovoltaïque 1 est donc avantageusement connue et stable dans ces deux dimensions.

Le principe de l'invention consiste à faire en sorte de venir éclairer la cellule photovoltaïque 1 à l'aide de la matrice de diodes électroluminescentes, lorsqu'elle passe dans le tunnel d'éclairement 20, l'éclairement étant réalisé de manière progressive, au fur et à mesure de l'avancement de la cellule photovoltaïque 1 à l'intérieur du tunnel d'éclairement.

Autrement dit, on vient juste allumer les diodes électroluminescentes qui sont en vis-à-vis d'une zone de la cellule photovoltaïque à traiter. Les autres diodes électroluminescentes de la matrice ne sont pas actives et restent éteintes.

Pour mettre en œuvre le procédé de l'invention, le système comporte une caméra 4 agencée en amont du tunnel d'éclairement 20, par rapport au sens de déplacement de la cellule photovoltaïque 1 sur le convoyeur 3.

Cette caméra 4 est configurée pour capturer une image IMG, avantageusement en noir et blanc, de chaque cellule photovoltaïque 1 déplacée par le convoyeur 3 avant son entrée dans le tunnel d'éclairement 20.

Pour mettre en œuvre le procédé, le système comporte également une unité de traitement et de commande UC chargée de :
- Recevoir des données d'un premier capteur de présence 5 associé à la caméra 4 ;
- Contrôler la caméra 4 lorsque la présence de la cellule photovoltaïque est détectée sous la caméra 4 ;
- Traiter les images IMG envoyées par la caméra 4 ;
- Déterminer la séquence de commande des diodes électroluminescentes LED de la matrice en fonction de l'image de la cellule photovoltaïque 1 traitée ;
- Recevoir des données en provenance d'un deuxième capteur de présence 6 associé au tunnel d'éclairement 20 ;
- Contrôler la matrice de diodes électroluminescente selon la séquence de commande déterminée lorsque l'entrée de la cellule photovoltaïque 1 est détectée à l'intérieur du tunnel d'éclairement 20 ;

Pour la mise en œuvre du procédé de l'invention, une cellule photovoltaïque 1 à traiter est positionnée sur le convoyeur 3 de manière à être mise en mouvement par le convoyeur 3.

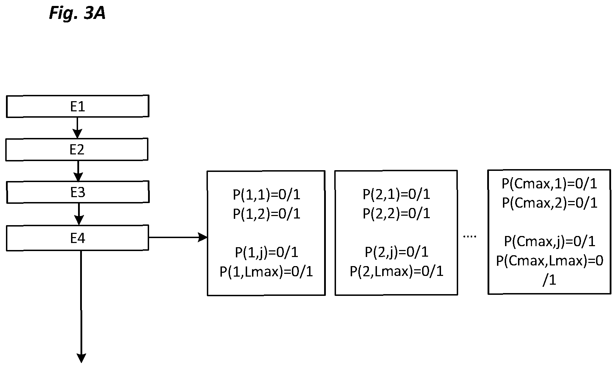

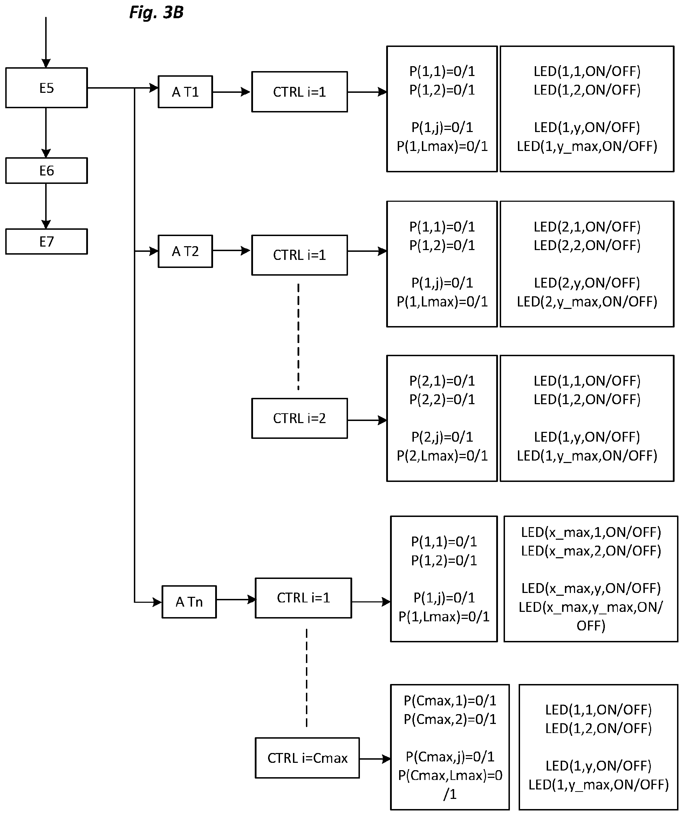

Le principe du procédé de l'invention est schématisé sur la figure 3A et sur la figure 3B et comporte les étapes suivantes :
- E1 : La présence de la cellule photovoltaïque est détectée sous la caméra ;
- E2 : La caméra capture une image de la cellule photovoltaïque présente, cette image montrant par exemple toute la surface de la cellule photovoltaïque sur la bande du convoyeur ;
- E3 : L'image capturée par la caméra est transférée à l'unité de traitement et de commande ;
- E4 : L'unité de traitement et de commande traite l'image capturée par la caméra ;

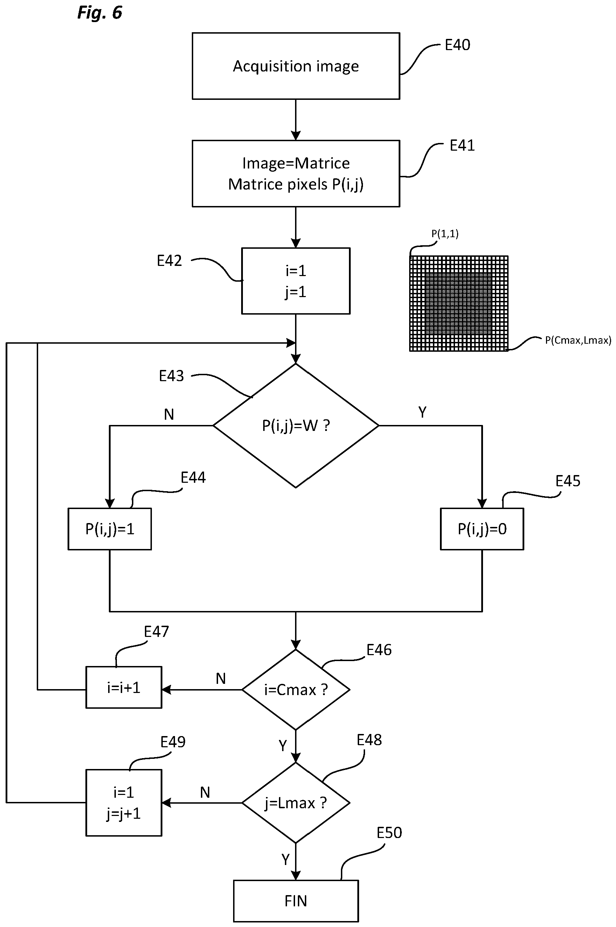

Le traitement effectué à l'étape E4 est défini par l'algorithme représenté sur la figure 6. Selon cet algorithme :
E40 : L'image IMG est acquise par la caméra. Un exemple d'image obtenu est représenté sur la figure 4. Sur cet exemple, la partie foncée correspond à la cellule photovoltaïque 1 et la partie claire correspond à son support, c'est-à-dire la bande du convoyeur 3.
E41 : L'image IMG est découpée en plusieurs colonnes et lignes de pixels (désignés P-voir ci-après). Le nombre de lignes de pixels correspond avantageusement au nombre de lignes de diodes électroluminescentes de la matrice du tunnel d'éclairement. Chaque colonne comporte ainsi par exemple 50 pixels. Chaque ligne comporte par exemple également 50 pixels. On obtient ainsi une image de 50x50 autour de la cellule photovoltaïque. Il faut noter que le choix du nombre de lignes de pixels correspond avantageusement au nombre de lignes de la matrice de diodes électroluminescentes. On peut ainsi s'assurer que toute la cellule photovoltaïque 1 sera irradiée dans les deux directions.

On a ainsi chaque pixel défini par :
P(i,j), avec i le numéro de colonne et j le numéro de ligne. Comme illustré par la figure 6, le traitement est ensuite le suivant :
E42 : on initialise i et j, avec i=1 et j=1.
E43 : Le traitement consiste ensuite à analyser chaque pixel de l'image obtenue, en effectuant un test sur chaque pixel. On vient par exemple tester si le pixel est blanc (=W) ou non, par le test P(i,j)=W ?
E44 : Lorsque le pixel est noir ou partiellement noir (branche N), on lui attribue la valeur 1.
E45 : Lorsque le pixel est blanc (=W) (branche Y), on lui attribue la valeur 0.
E46 : on effectue un test pour voir si on a bien traité toutes les colonnes, avec i=Cmax ?
E47 : Si le test est négatif (branche N), on incrémente i de 1 pour passer à la colonne suivante.
E48 : Si le test est positif (branche Y), on effectue un test pour savoir si toutes les lignes ont été traitées, avec j=Lmax ?
E49 : Si le test est négatif (branche N), on repasse i à 1 et on incrémente j de 1 pour passer à la ligne suivante.
E50 : Si le test est positif (branche Y), la pixellisation de l'image est terminée.

A titre d'exemple, on obtient ainsi :
Pour la première colonne de l'image, les états suivants :
P(1,1)=0/1 désignant l'état (0 ou 1) pour le pixel de la colonne 1 et de la ligne 1.
P(1,2)=0/1 désignant l'état (0 ou 1) pour le pixel de la colonne 1 et de la ligne 2.
P(1,j)=0/1 désignant l'état (0 ou 1) pour le pixel de la colonne 1 de la ligne j.
P(1,Lmax)=0/1 désignant l'état (0 ou 1) pour le pixel de la colonne 1 et de la dernière ligne Lmax de la matrice de l'image.

Pour la deuxième colonne de l'image :
P(2,1)=0/1 désignant l'état (0 ou 1) pour le pixel de la colonne 2 et de la ligne 1.
P(2,2)=0/1 désignant l'état (0 ou 1) pour le pixel de la colonne 2 et de la ligne 2.
P(2,j)=0/1 désignant l'état (0 ou 1) pour le pixel de la colonne 2 de la ligne j.
P(2,Lmax)=0/1 désignant l'état (0 ou 1) pour le pixel de la colonne 2 et de la dernière ligne Lmax de la matrice de l'image.

Pour la colonne i de l'image :
P(i,1)=0/1 désignant l'état (0 ou 1) pour le pixel de la colonne i et de la ligne 1.
P(i,2)=0/1 désignant l'état (0 ou 1) pour le pixel de la colonne i et de la ligne 2.
P(i,j)=0/1 désignant l'état (0 ou 1) pour le pixel de la colonne i de la ligne j.
P(i,Lmax)=0/1 désignant l'état (0 ou 1) pour le pixel de la colonne i et de la dernière ligne Lmax de la matrice de l'image.

Pour la dernière colonne Cmax de la matrice de l'image.
P(Cmax,1)=0/1 désignant l'état (0 ou 1) pour le pixel de la colonne Cmax et de la ligne 1.
P(Cmax,2)=0/1 désignant l'état (0 ou 1) pour le pixel de la colonne Cmax et de la ligne 2.
P(Cmax,j)=0/1 désignant l'état (0 ou 1) pour le pixel de la colonne Cmax de la ligne j.
P(Cmax,Lmax)=0/1 désignant l'état (0 ou 1) pour le pixel de la colonne Cmax et de la dernière ligne Lmax de la matrice de l'image.

E5 : Une fois l'image IMG traitée selon l'algorithme précédent, l'unité de traitement et de commande UC détermine la séquence de contrôle des diodes électroluminescentes LED de la matrice.

La séquence de contrôle consiste ainsi à activer (allumer) les diodes électroluminescentes qui se trouvent chacune en vis-à-vis d'un pixel de l'image traitée qui est à l'état 1 et à ne pas activer (maintenir éteinte) les diodes électroluminescentes qui se trouvent en vis-à-vis d'un pixel qui est à l'état 0. Selon l'état d'avancement de la cellule photovoltaïque dans le tunnel, chaque diode électroluminescente de la matrice peut se trouver en vis-à-vis d'une zone à ne pas éclairer ou devant une zone à éclairer. Les zones à éclairer sont donc identifiées par les pixels à l'état 0 et celles à éclairer sont identifiées par les pixels à l'état 1.

Autrement dit, cette séquence de contrôle tient compte de l'état d'avancement de la cellule photovoltaïque à l'intérieur du tunnel d'éclairement 20, à l'aide du convoyeur 3. Chaque diode électroluminescente de la matrice prend l'état ON ou OFF, selon qu'elle est amenée à être en vis-à-vis d'une zone à éclairer ou à ne pas éclairer.

La séquence de contrôle tient également compte de la vitesse du convoyeur 3 et donc de la vitesse de déplacement de la cellule photovoltaïque 1 à l'intérieur du tunnel d'éclairement.

La cadence de changement d'état des diodes électroluminescentes est en effet définie par la vitesse d'avancement du convoyeur 3.

Grâce à la vitesse d'avancement du convoyeur 3, on vient déterminer chaque instant où l'on vient contrôler l'état des diodes électroluminescentes.

Chaque instant T de la séquence de contrôle est ainsi défini par la durée mise par la cellule pour avancer d'une colonne de diodes électroluminescentes.

En considérant que :
- Le convoyeur avance à une vitesse V_x,
- La distance qui existe entre deux colonnes de diodes électroluminescentes consécutives vaut L_x,

On peut en conclure que la durée T_x pour passer d'une colonne x de diodes électroluminescentes de la matrice à la colonne x+1 de diodes électroluminescentes est : T_x=L_x/V_x.

L'unité de commande et de traitement UC vient ainsi créer cette séquence de contrôle en modélisant l'avancée de l'image pixellisée IMG à la vitesse d'avancée du convoyeur 3 dans le tunnel d'éclairement 20.

Partant de ces éléments, l'unité de traitement et de commande UC crée la séquence de contrôle des diodes électroluminescentes de la matrice en définissant l'état que doit prendre chaque diode électroluminescente de la matrice, à chaque instant de la séquence :

### A T1 :

Seule la première colonne de pixels de l'image se trouve en vis-à-vis d'une colonne de diodes électroluminescentes de la matrice, étant donné que la cellule vient juste de commencer à rentrer dans le tunnel d'éclairement.

La première colonne (i=1) de l'image est formée des pixels P :

```
 P(1, 1)=0
 P(1, 2)=0
 P(1, 3)=1
 P(1, 4)=1
 ...
 P(1, Lmax)=0
```

Pour chacun de ces pixels, on vient donc activer la diode électroluminescente correspondante :

```
 LED(1, 1,OFF)
 LED(1, 2, OFF)
 LED(1, 3, ON)
 LED(1, 4, ON)
 ...
 LED(1, Lmax, OFF)
```

### A T2 :

A cet instant, deux colonnes de pixels de l'image sont à l'intérieur du tunnel d'éclairement. La première colonne de pixels (i=1) a avancé d'un pas et se trouve en vis-à-vis de la deuxième colonne de diodes électroluminescentes (x=2).

Pour les pixels de la première colonne (i=1) :

```
 P(1, 1)=0
 P(1, 2)=0
 P(1, 3)=1
 P(1, 4)=1
 ...
 P(1, Lmax)=0
```

On vient contrôler la deuxième colonne (x=2) de diodes électroluminescentes :

```
 LED(2, 1,OFF)
 LED(2, 2, OFF)
 LED(2, 3, ON)
 LED(2, 4, ON)
 ...
 LED(2, y_max, OFF)
```

Et pour les pixels de la deuxième colonne (i=2), on a :

```
 P(2, 1)=0
 P(2, 2)=0
 P(2, 3)=1
 P(2, 4)=1
 ...
 P(2, Lmax)=0
```

On vient ainsi contrôler la première colonne (x=1) de diodes électroluminescentes :

```
 LED(1, 1,OFF)
 LED(1, 2, OFF)
 LED(1, 3, ON)
 LED(1, 4, ON)
 ...
 LED(1, y_max, OFF)
```

### A Tn :

Ce principe est donc dupliqué jusqu'à l'instant Tn où la dernière colonne de pixels de l'image de la cellule photovoltaïque se trouve à l'intérieur du tunnel d'éclairement en vis-à-vis d'une colonne de diodes électroluminescentes. La dernière colonne de diodes électroluminescentes est alors désignée x_max mais il faut considérer que le tunnel d'éclairement peut comporter un nombre de colonnes de diodes électroluminescentes plus important, de sorte que la séquence de contrôle recommence pour la colonne suivante (x=x_max+1).

Pour les pixels de la première colonne (i=1) :

```
 P(1, 1)=0
 P(1, 2)=0
 P(1, 3)=1
 P(1, 4)=1
 ...
 P(1, Lmax)=0
```

On vient contrôler la colonne (x=x_max) de diodes électroluminescentes :

```
 LED(x_max, 1,OFF)
 LED(x_max, 2, OFF)
 LED(x_max, 3, ON)
 LED(x_max, 4, ON)
 ...
 LED(x_max, y_max, OFF)
```

Pour les pixels de la dernière colonne (i=Cmax) :

```
 P(Cmax, 1)=0
 P(Cmax, 2)=0
 P(Cmax, 3)=1
 P(Cmax, 4)=1
 ...
 P(Cmax, Lmax)=0
```

On vient contrôler la première colonne (x=1) de diodes électroluminescentes :

```
 LED(1, 1,OFF)
 LED(1, 2, OFF)
 LED(1, 3, ON)
 LED(1, 4, ON)
 ...
 LED(1, y_max, OFF)
```

E6 : Une fois la séquence de contrôle terminée, l'unité de traitement et de commande UC mémorise la séquence.

E7 : La séquence de contrôle élaborée est ensuite exécutée dès l'instant que le deuxième capteur de présence 6 détecte l'entrée de la cellule photovoltaïque 1 dans le tunnel d'éclairement 20.

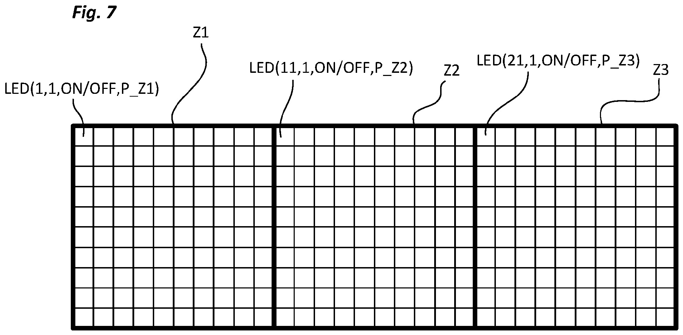

Il faut noter qu'il est également possible de jouer sur la puissance générée par chaque diode électroluminescente. Dans ce cas, en référence à la figure 7, on vient diviser la matrice de diodes électroluminescentes en plusieurs zones, par exemple trois zones Z1, Z2, Z3. Chaque zone comporte par exemple autant de colonnes de diodes électroluminescentes que de colonnes de pixels de l'image de la cellule photovoltaïque. Une première zone Z1 est contrôlée pour éclairer à une première puissance P_Z1, une deuxième zone pour éclairer à une deuxième puissance P_Z2 (par exemple supérieure à P_Z1) jusqu'à une dernière zone (Z3 sur la figure 7) définie pour éclairer à une puissance P_Zn (supérieure à PZn-1 - c'est-à-dire P_Z3 sur la figure 7). Sur la figure 7, le nombre de zones et le nombre de diodes électroluminescentes sont indiqués en exemple et ne sont pas à considérer de manière limitative.

A chaque fois que la présence d'une nouvelle cellule photovoltaïque 1 est détectée à l'entrée du tunnel d'éclairement par le capteur de présence 6, la séquence de contrôle des diodes électroluminescentes est exécutée.

Il faut noter que l'acquisition d'image à l'aide de la caméra 4 peut être effectuée une seule fois pour toutes les cellules photovoltaïques convoyées, dès l'instant que les cellules photovoltaïques sont toutes identiques et toujours convoyées de façon identique, calées sur le convoyeur 3 dans une même position par rapport à la matrice de diode électroluminescentes.

Pour augmenter la fiabilité, la capture d'image peut cependant être effectuée pour chaque cellule photovoltaïque 1, de sorte que la séquence de contrôle se trouve recalculée à chaque fois.

La solution de l'invention présente ainsi de nombreux avantages, parmi lesquels :
- Une consommation d'énergie maitrisée et adaptée à la taille de la cellule photovoltaïque ;
- Une solution simple de contrôle, utilisant des moyens facilement disponibles (caméra, convoyeur, matrice de diodes électroluminescentes) ;
- Une solution adaptée à la forme de la cellule photovoltaïque ;
- Une solution qui permet de venir créer une opération de bonification personnalisée, en pouvant jouer notamment sur la puissance émise par chaque diode électroluminescente ;

## Revendications

1. Procédé de traitement pour augmenter le rendement d'une cellule photovoltaïque (1), **caractérisé en ce qu'**il comporte des étapes de :
- Positionnement de la cellule photovoltaïque (1) sur un convoyeur (3) le long duquel est positionnée une matrice de sources lumineuses, chaque source lumineuse de la matrice étant adressable et contrôlable de manière individualisée en prenant un premier état dit actif dans lequel elle est allumée ou un deuxième état dit inactif dans lequel elle est éteinte, ladite matrice de sources lumineuses comportant plusieurs lignes et colonnes de sources lumineuses juxtaposées,
- Acquisition d'une image (IMG) de la cellule photovoltaïque (1) sur le convoyeur (3) à l'aide d'une caméra (4),
- Division de l'image acquise en plusieurs zones, dites premières zones à éclairer et deuxièmes zones à ne pas éclairer,
- Création d'une séquence de contrôle des sources lumineuses de la matrice à l'aide de l'image divisée en plusieurs zones,
- Ladite séquence de contrôle étant définie par plusieurs instants successifs,
- Détection d'un premier instant auquel la cellule photovoltaïque est présente en vis-à-vis d'une première colonne de la matrice de sources lumineuses et exécution de ladite séquence de contrôle des sources lumineuses à partir dudit premier instant détecté, en tenant compte de l'image acquise divisée en plusieurs zones,
- A chaque instant de la séquence de contrôle et à partir de l'image divisée en plusieurs zones, mettre dans l'état actif chaque source lumineuse située en vis-à-vis d'une première zone à éclairer définie sur l'image acquise et mettre dans l'état inactif chaque source lumineuse située en vis-à-vis d'une deuxième zone à ne pas éclairer définie sur l'image acquise.

2. Procédé selon la revendication 1, **caractérisé en ce que** lesdits instants successifs de la séquence de contrôle sont déterminés en tenant compte de la vitesse d'avancée du convoyeur (3).

3. Procédé selon la revendication 1 ou 2, **caractérisé en ce que** chaque zone desdites plusieurs zones est définie par au moins un pixel.

4. Procédé selon la revendication 3, **caractérisé en ce que** l'image acquise est en noir et blanc et **en ce que** l'étape de division de l'image en plusieurs zones consiste à :
- Mémoriser un état 0 ou 1 lorsque le pixel de l'image (IMG) acquise est blanc,
- Mémoriser respectivement l'état 1 ou 0 lorsque le pixel de l'image acquise est noir.

5. Procédé selon la revendication 4, **caractérisé en ce que** chaque source lumineuse de la matrice de sources lumineuses est formée d'une diode électroluminescente (LED) et **en ce que**, dans la séquence de contrôle, l'état de chaque diode électroluminescente est déterminé en fonction de l'état affecté à chaque pixel de l'image.

6. Procédé selon l'une des revendications 1 à 5, **caractérisé en ce que** la séquence de contrôle consiste à commander chaque diode électroluminescente de la matrice de diodes électroluminescentes pour émettre à une puissance déterminée en fonction de sa position dans la matrice de diodes électroluminescentes.

7. Système de traitement pour augmenter le rendement d'une cellule photovoltaïque (1) employé pour mettre en œuvre le procédé tel que défini dans l'une des revendications précédentes, **caractérisé en ce qu'**il comporte :
- Un convoyeur (3) le long duquel est positionnée une matrice de sources lumineuses, chaque source lumineuse de la matrice étant adressable et contrôlable de manière individualisée en prenant un premier état dit actif dans lequel elle est allumée ou un deuxième état dit inactif dans lequel elle est éteinte, ladite matrice de sources lumineuses comportant plusieurs lignes et colonnes de sources lumineuses juxtaposées,
- Une caméra configurée pour acquérir une image (IMG) de la cellule photovoltaïque (1) sur le convoyeur (3),
- Une unité de traitement et de commande (UC) configurée pour :
∘ Diviser chaque image acquise en plusieurs zones, dites premières zones à éclairer et deuxièmes zones à ne pas éclairer,
∘ Créer une séquence de contrôle des sources lumineuses de la matrice à l'aide de l'image divisée en plusieurs zones,
∘ Ladite séquence de contrôle étant définie par plusieurs instants successifs,
- Des moyens de détection d'un premier instant auquel la cellule photovoltaïque est présente en vis-à-vis d'une première colonne de la matrice de sources lumineuses,
- Ladite unité de traitement et de commande (UC) étant configurée pour exécuter ladite séquence de contrôle des sources lumineuses à partir dudit premier instant détecté, en tenant compte de l'image acquise divisée en plusieurs zones,
- A chaque instant de la séquence de contrôle et à partir de l'image divisée en plusieurs zones, l'unité de traitement est configurée pour commander dans l'état actif chaque source lumineuse située en vis-à-vis d'une première zone à éclairer définie sur l'image acquise et commander dans l'état inactif chaque source lumineuse située en vis-à-vis d'une deuxième zone à ne pas éclairer définie sur l'image acquise.

8. Système selon la revendication 7, **caractérisé en ce que** lesdits instants successifs de la séquence de contrôle sont déterminés en tenant compte de la vitesse d'avancée du convoyeur (3).

9. Système selon la revendication 7 ou 8 **caractérisé en ce que** chaque zone desdites plusieurs zones est définie par au moins un pixel.

10. Système selon la revendication 9, **caractérisé en ce que** l'image acquise est en noir et blanc et **en ce que** l'unité de traitement et de commande (UC) est configurée pour diviser l'image en plusieurs zones en :
- Mémorisant un état 0 ou 1 lorsque le pixel de l'image (IMG) acquise est blanc,
- Mémorisant respectivement l'état 1 ou 0 lorsque le pixel de l'image acquise est noir.

11. Système selon la revendication 10, **caractérisé en ce que** chaque source lumineuse de la matrice de sources lumineuses est formée d'une diode électroluminescente et **en ce que**, dans la séquence de contrôle, l'état de chaque diode électroluminescente est déterminé en fonction de l'état affecté à chaque pixel de l'image.

12. Système selon l'une des revendications 7 à 11, **caractérisé en ce que** la séquence de contrôle consiste à commander chaque diode électroluminescente de la matrice de diodes électroluminescentes pour émettre à une puissance déterminée en fonction de sa position dans la matrice de diodes électroluminescentes.

13. Système selon l'une des revendications 7 à 12, **caractérisé en ce que** la matrice de sources lumineuses est intégrée à un tunnel d'éclairement (20) traversé par le convoyeur (3).
